# EUROPÄISCHE PATENTANMELDUNG

(11) **EP 2 110 853 A2**
(43) Veröffentlichungstag der Anmeldung: **21.10.2009**
(21) Anmeldenummer: 09005275.4
(22) Anmeldetag: 11.04.2009
(51) Int. Cl.: H01L 25/07

(54) **Anordnung in Druckkontaktausführung mit einem Leistungshalbleitermodul**

(30) Priorität: 15.04.2008 DE 102008018793
(71) Anmelder: SEMIKRON Elektronik GmbH & Co. KG, 90431 Nürnberg (DE)
(72) Erfinder: Reusser, Lars, 96114 Hirschaid (DE); Lederer, Marco, 90453 Nürnberg (DE)

(57) **Zusammenfassung**

Die Erfindung beschreibt eine Anordnung in Druckkontaktierung mit einem Leistungshalbleitermodul, bestehend aus einem Gehäuse, mindestens einem elektrisch isolierenden Substrat, mit einer Mehrzahl darauf befindlicher gegeneinander isolierter metallischer Verbindungsbahnen, mit Leistungshalbleiterbauelementen und mit Anschlussleitern, mit einer außerhalb des Gehäuses angeordneten Leiterplatte und mit einem formstabilen Druckstück, welches aus einem Kunststoffformteil und einer Metalleinlage besteht und wobei das Kunststoffformteil mindestens einen Fixiervorsprung mit einer Ausnehmung entlang seiner Hochachse und die Metalleinlage eine entsprechend zugeordnete Aussparung aufweisen.

## Beschreibung

Die Erfindung beschreibt eine Anordnung in Druckkontaktierung für kompakte Leistungshalbleitermodule. Moderne Ausgestaltungen derartiger Leistungshalbleitermodule mit hoher Leistung bezogen auf ihre Baugröße, die Ausgangspunkt dieser Erfindung sind, sind bekannt aus der DE 196 30 173 C2.

Die DE 196 30 173 C2 offenbart ein Leistungshalbleitermodul zur direkten Montage auf einem Kühlkörper, bestehend aus einem Gehäuse und einem elektrisch isolierenden Substrat welches seinerseits aus einem Isolierstoffkörper mit einer Mehrzahl darauf befindlicher gegeneinander isolierter metallischer Verbindungsbahnen und darauf befindlichen und mit diesen Verbindungsbahnen schaltungsgerecht verbundenen Leistungshalbleiterbauelementen besteht. Die externe elektrische Verbindung zu einer außerhalb des Gehäuses angeordneten Leitplatte erfolgt mittels zumindest teilweise federnd gestalteter Anschlussleiter.

Das Leistungshalbleitermodul weist weiterhin mindestens eine zentral angeordnete Ausnehmung zur Durchführung einer Schraubverbindung auf. Diese dient zusammen mit einem auf der dem Leistungshalbleitermodul abgewandeten Seite der Leiterplatte angeordneten und auf dieser flächig aufliegenden, formstabilen Druckstück der Druckkontaktierung des Moduls. Diese Druckkontaktierung erfüllt gleichzeitig zwei Aufgaben: einerseits die sichere elektrische Kontaktierung der Anschlusselemente mit der Leiterplatte und andererseits die thermische Kontaktierung des Leistungshalbleitermoduls mit einem Kühlkörper, wobei beide Kontaktierungen reversibel sind.

Die DE 199 03 875 C2 zeigt ein solches Druckstück, bestehend aus einer den Kunststoff vollständig ummantelnden Metallseele. Dieses Druckstück weist zusätzlich Erhebungen auf, die der Durchführung und elektrischen Isolierung von federnden Anschlusselementen zur Verbindung des Substrates mit einer Steuerplatine eines Treibers dienen.

Die DE 103 06 643 B4 beschreibt ebenfalls ein solches Druckstück, welches bevorzugt aus einem formstabilen Kunststoffformteil und einem Metalleinsatz ausgestaltet ist, welcher in den Kunststoff eingespritzt oder in eine Aussparung in diesen eingelegt sein kann. Hierbei dient der Metalleinsatz der Stabilisierung gegenüber einwirkender mechanischer Kräfte bei der Druckkontaktierung. Weiterhin weist das Druckstück mindestens eine gemeinsame Ausnehmung von Kunststoffformteil und Metalleinlage auf, welche eine seine beiden Hauptflächen verbindende Ausnehmung zur Aufnahme der Schraubverbindung ausbildet.

Nachteilig an der Ausgestaltung derartiger Leistungshalbleitermodule ist, dass durch die Betriebstemperatur des Leistungshalbleitermoduls das Druckstück einer thermischen Belastung ausgesetzt ist, welche durch die unterschiedlichen Wärmeausdehnungskoeffizienten von Kunststoff und Metall zu hohen mechanischen Spannungen beider Werkstoffe führt. In der Folge führt der thermische Lastwechsel zu Ermüdungsrissen vor allem im Kunststoffformteil des Druckstückes, welche die Isolationsfähigkeit des Leistungshalbleitermoduls beeinträchtigen.

Der vorliegenden Erfindung liegt die Aufgabe zu Grunde eine Anordnung in Druckkontaktausführung mit einem Leistungshalbleitermodul vorzustellen, wobei das Druckstück aus einem formstabilen Kunststoffformteil und einer Metalleinlage ausgestaltet ist, welche gegen Herausfallen geschützt angeordnet ist und wobei die mechanischen Spannungen, bedingt durch die unterschiedlichen Wärmeausdehnungskoeffizienten der beiden Werkstoffe, minimiert werden.

Diese Aufgabe wird gelöst durch eine Anordnung nach dem Anspruch 1, spezielle Ausgestaltungen finden sich in den Unteransprüchen.

Der Grundgedanke der Erfindung geht aus von einem Leistungshalbleiterbauelement mit Grundplatte oder zur direkten Montage auf einem Kühlkörper nach dem genannten Stand der Technik bestehend aus einem Gehäuse mit mindestens einem darin angeordneten elektrisch isolierenden Substrat. Dieses Substrat besteht vorzugsweise aus einem Isolierstoffkörper mit einer Mehrzahl auf seiner ersten Hauptfläche befindlicher gegeneinander isolierter metallischer Verbindungsbahnen sowie ebenfalls bevorzugt aus einer auf seiner zweiten Hauptfläche angeordneten flächigen metallischen Schicht. Auf den Verbindungsbahnen der ersten Hauptfläche und mit diesen Verbindungsbahnen schaltungsgerecht verbunden sind eine Mehrzahl von Leistungshalbleiterbauelementen angeordnet.

Als Anschlusselemente sowohl für Last- als auch für Steueranschlüsse weist das Leistungshalbleitermodul zumindest teilweise federnd gestaltete Anschlussleiter auf. Diese Anschlussleiter stellen die elektrische Verbindung der Verbindungsbahnen mit einer außerhalb des Gehäuses angeordneten Leiterplatte und den darauf angeordneten externen Verbindungsbahnen her. Der sichere elektrische Kontakt zwischen den Anschlussleitern und den externen Verbindungsbahnen der Leiterplatte wird mittels einer Anordnung zur Druckkontaktierung erzielt. Die Druckeinleitung dieser Anordnung erfolgt mittels mindestens einem mit der Grundplatte oder dem Kühlkörper verbundenen formstabilen Druckstück, wobei diese Verbindung vorzugsweise mittels einer Schraubverbindung hergestellt wird. Weiterhin weist das Druckstück eine Anordnung mit einem elektrisch isolierenden Kunststoffformteil und einer Metalleinlage auf, welche in den Kunststoff eingespritzt oder bevorzugt in eine wannenförmige Aussparung im Kunststoffformteil eingelegt wird. Gemäß dem Stand der Technik weisen Kunststoffformteil und Metalleinlage bevorzugt mindestens eine gemeinsame Aussparung auf, sodass das Druckstück in seiner Anordnung mindestens eine seine beiden Hauptflächen verbindende Aussparung zur Aufnahme der Schraubverbindung ermöglicht.

Erfindungsgemäß weist das Kunststoffformteil an mindestens einer Stelle einen einstückig aus dem Material ausgebildeten Fixierungsvorsprung und mindestens eine ihm entsprechend zugeordnete Ausnehmung in der Metalleinlage auf. Auf diese Art ergibt sich bei der Anordnung von Kunststoffformteil und Metalleinlage ein spezifischer Kraftschluss zwischen der äußeren Mantelfläche des Fixierungsvorsprungs und der inneren Mantelfläche der Aussparung der Metalleinlage, wobei der Umfang der Mantelfläche des Fixierungsvorsprungs exakt gleich groß oder einige Mikrometer größer ist als der Umfang der Innenfläche der ihm zugeordneten Aussparung in der Metalleinlage. Hierbei ist von Vorteil, dass eine solche Anordnung eine ausreichende, jedoch leicht reversible Fixierung von Kunststoffformteil und Metalleinlage ermöglicht, welche bis zur endgültigen Schraubverbindung einen sicheren Transport und Montage der Anordnung gegen ungewolltes Auseinanderfallen des Kunststoffformteils und der Metalleinlage und gegen deren Verlust ermöglicht.

Zur Lösung des aus dem Stand der Technik bekannten Problems der thermischen Belastung zwischen Kunststoffformteil und Metalleinlage, welches durch ihre unterschiedlichen Ausdehnungskoeffizienten bedingt ist, weist der mindestens eine Fixierungsvorsprung mindestens eine Ausnehmung auf. Diese mindestens eine Ausnehmung, welche bevorzugt fluchtend zu einer der Flächendiagonalen des Druckstücks ausgerichtet ist, ermöglicht dem Kunststoff im Bereich des Fixierungsvorsprungs bei unterschiedlichen Betriebstemperaturen eine entsprechende Flexibilität bezüglich seiner Wärmeausdehnung, wodurch Ermüdungsrisse des Materials bedingt durch die thermische Belastung verringert oder sogar vermieden werden können und darüber hinaus durch eine zusätzlich verbesserte Konvektionsströmung im Kunststoffformteil eine verbesserte Kühlung des Druckstücks und der angeordneten Leiterplatte bewirkt.

Die Erfindung wird anhand von Ausführungsbeispielen in Verbindung mit den Fig. 1 bis 6c näher erläutert.
Fig. 1 zeigt im Querschnitt eine vereinfachte Darstellung einer Anordnung gemäß dem beschriebenen Stand der Technik.
Fig. 2 zeigt in dreidimensionaler Ansicht eine vereinfachte Darstellung einer Anordnung gemäß dem beschriebenen Stand der Technik.
Fig. 3 zeigt in dreidimensionaler Ansicht eine vereinfachte Darstellung einer erfindungsgemäßen Weiterbildung der Anordnung.
Fig. 4 zeigt in dreidimensionaler Darstellung das Druckstück der erfindungsgemäßen Anordnung sowie einen vergrößerten Ausschnitt des Fixierungsvorsprungs mit der ihm zugeordneten Aussparung in der Metalleinlage.
Fig. 5 zeigt einen vergrößerten Ausschnitt des Druckstücks ohne die Metalleinlage und dementsprechend den Fixierungsvorsprung ohne die ihm zugeordneten Aussparung.
Fig. 6a, 6b und 6c zeigen weitere Ausführungsformen des Fixierungsvorsprunges.

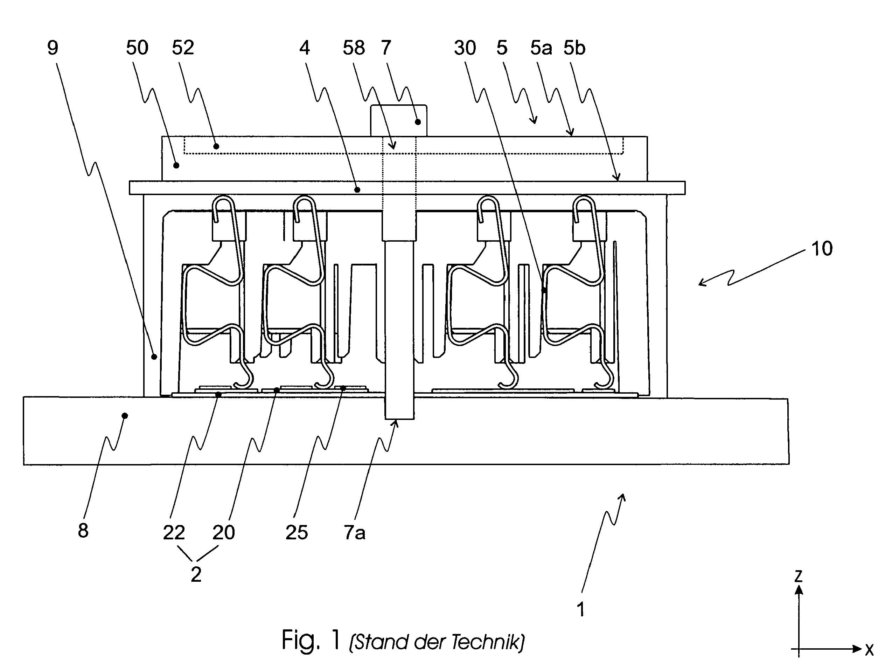

Fig. 1 zeigt im Querschnitt eine vereinfachte Darstellung einer Anordnung (1) gemäß dem beschriebenen Stand der Technik. Das Leistungshalbleitermodul (10) weist ein Gehäuse (9), mindestens ein elektrisch isolierendes Substrat (2), bestehend aus einem Isolierstoffkörper (20) mit einer Mehrzahl darauf befindlicher gegeneinander isolierter metallischer Verbindungsbahnen (22) und mit darauf befindlichen und mit diesen Verbindungsbahnen schaltungsgerecht verbundenen Leistungshalbleiterbauelementen (25) auf. Weiterhin dargestellt sind die federnd ausgestalteten Anschlussleiter (30), welche die Leistungshalbleiterbauelemente bzw. die Verbindungsbahnen mit der außerhalb des Gehäuses angeordneten Leiterplatte (4) kontaktiert. Weiterhin dargestellt sind ein Kühlkörper (8) und ein flächiges formstabiles Druckstück (5) mit einem Kunststoffformteil (50) und einer Metalleinlage (52) zur Druckkontaktierung der Leiterplatte (4) mit den federnd ausgestalteten Anschlussleitern (30). Das Druckstück weist weiterhin eine Aussparung (58) auf, die die beiden Hauptflächen (5a, 5b) des Druckstücks verbindet und dazu dient, mittels einer Schraubverbindung (7, 7a) das Druckstück mit Druck zu beaufschlagen und gleichzeitig die zuverlässige Montage des Leistungshalbleitermoduls mit dem Kühlkörper, der Leiterplatte und dem Druckstück ermöglicht.

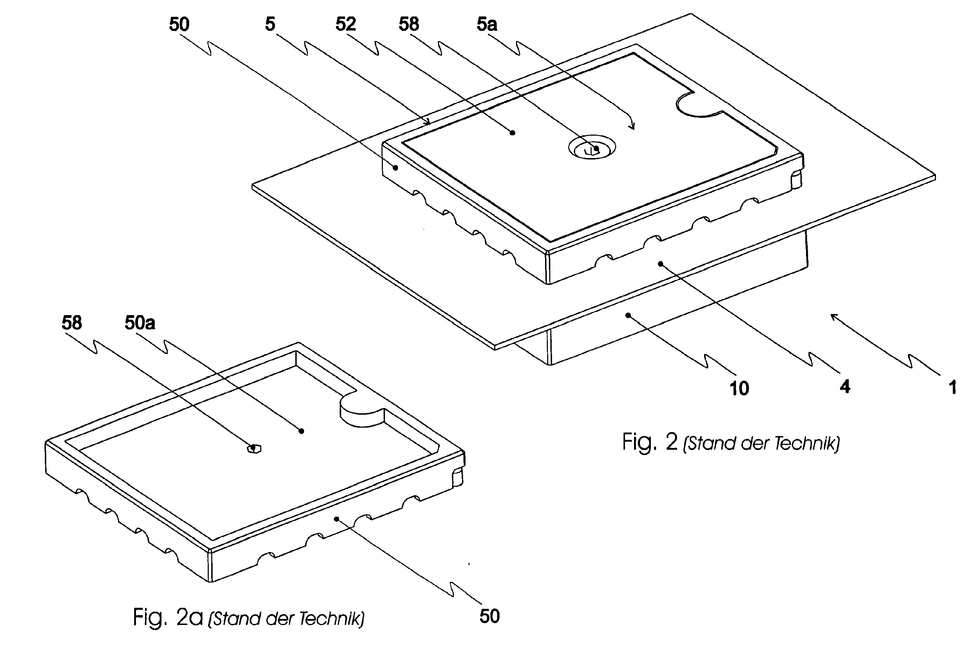

Fig. 2 zeigt in dreidimensionaler vereinfachter Darstellung einer Anordnung (1) gemäß dem beschriebenen Stand der Technik. Dargestellt ist das Leistungshalbleitermodul (10) die Leiterplatte (4) und das formstabile Druckstück (5), welches seinerseits eine Anordnung aus einem formstabilen elektrisch isolierenden Kunststoffformteil (50) und einer Metalleinlage (52) ist, wobei die Metalleinlage in eine wannenförmige Vertiefung des Kunststoffformteils eingelegt ist und somit die Stabilität bei gleichzeitig geringer Dicke des Druckstücks gewährleistet. In der Anordnung bilden das Kunststoffformteil und die Metalleinlage gemeinsam die erste (5a) und zweite (5b, vgl. Fig. 1) Hauptfläche des Druckstücks aus. Weiterhin dargestellt ist die Ausnehmung (58) im Druckstück, die die beiden Hauptflächen des Druckstücks verbindet und zur Aufnahme der Schraubverbindung dient, welche bei Montage eine Druckbeaufschlagung erlaubt.

Fig. 2a zeigt in dreidimensionaler Darstellung das formstabile elektrisch isolierende Kunststoffformteil (50) ohne die eingelegte Metalleinlage (52), sodass weiterhin eine Hilfsfläche (50a) sichtbar wird, welche sich aus der dem Leistungshalbleitermodul abgewandten Oberfläche des Kunststoffformteiles ergibt und auf welcher die Metalleinlage, wenn eingelegt, vollflächig aufliegt.

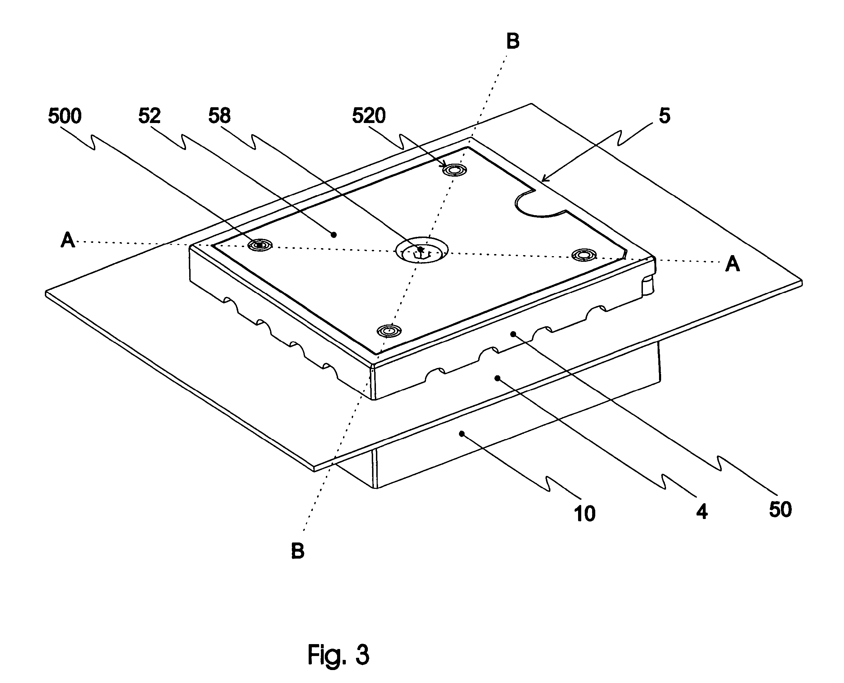

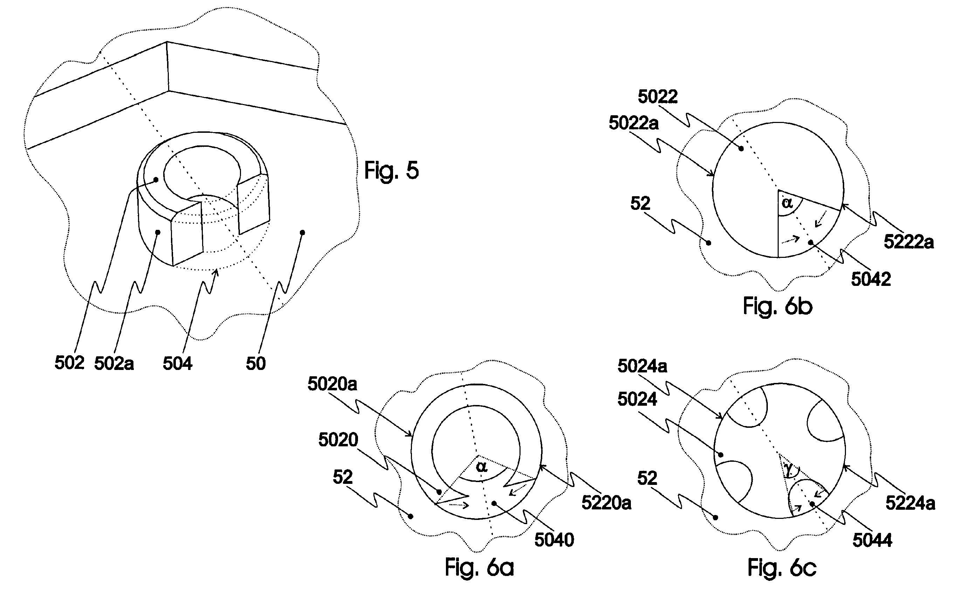

Fig. 3 zeigt in dreidimensionaler vereinfachter Darstellung eine erfindungsgemäße Weiterbildung der Anordnung, wobei baugleiche Elemente zu Figur 2 nicht extra beschrieben sind. Das Kunststoffformteil (50) weist hierbei auf seiner Hilfsfläche (50a, vgl. Fig. 5) entlang seiner Flächendiagonalen (A-A, B-B) benachbart zu seinen Ecken vier Fixierungsvorsprünge (500) auf, welche als Hohlzylinder einstückige Bestandteile des Kunststoffformteiles sind. Dementsprechend weist die Metalleinlage (50) vier den Fixierungsvorsprüngen zugeordnete Aussparungen (520) auf, sodass die Mantelflächen der Fixierungsvorsprünge und die Innenflächen der den Fixierungsvorsprüngen entsprechend zugeordneten Aussparungen beim Einlegen der Metalleinlage in die wannenförmige Vertiefung im Kunststoffformteil einen Kraftschluss bilden und dadurch ein Herausfallen der Metalleinlage verhindert wird.

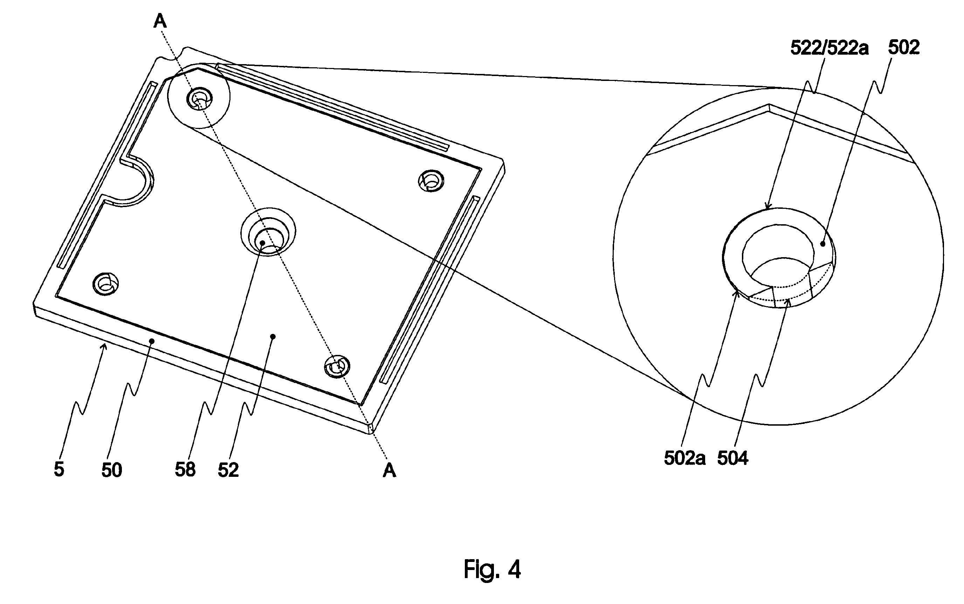

Fig. 4 zeigt in dreidimensionaler Darstellung das Druckstück der erfindungsgemäßen Anordnung sowie einen vergrößerten Ausschnitt eines Fixierungsvorsprungs (502) und dessen Mantelfläche (502a) mit der ihm entsprechend zugeordneten Aussparung (522) bzw. ihrer Innenfläche (522a) in der Metalleinlage, wobei die Anordnung der Fixierungsvorsprünge und der ihnen entsprechend zugeordneten Aussparungen der Beschreibung in Fig. 3 entspricht. Weiterhin weisen die Fixierungsvorsprünge (502) jeweils eine Ausnehmung (504) entlang ihrer Hochachse auf, welche fluchtend zu den Flächendiagonalen der Hilfsfläche (50a) des Kunststoffformteiles (50) in Richtung der zweiten Aussparung (58) angeordnet sind und die Mantelfläche (502a) des Fixiervorsprungs um 25 von 100 reduzieren.

Fig. 5 zeigt in dreidimensionaler Darstellung einen vergrößerten Ausschnitt des Kunststoffformteils (50) ohne die Metalleinlage und dementsprechend den Fixierungsvorsprung (502) in Form eines Hohlzylinders ohne eine ihm zugeordneten Aussparung. Hierbei reduziert eine Ausnehmung (504) die Mantelfläche (502a) des Fixierungsvorsprungs um 20 von 100.

Fig. 6 zeigt in Aufsicht Fixiervorsprünge (5020, 5022, 5024) und die ihnen entsprechend zugeordneten ersten Aussparungen (5220, 5222, 5224) in der Metalleinlage (52) mit verschiedenen Ausführungsformen der Ausnehmungen (5220, 5222, 5224) in den Fixierungsvorsprüngen (5020, 5022, 5024) und einer schematischen Andeutung der möglichen Wärmeausdehnung des Kunststoffformteiles in Form von Vektoren, wobei jede Ausnehmung einen spezifischen Öffnungswinkel (α, β, γ) aufweist.
Fig. 6a zeigt eine kreissegmentförmige Ausnehmung (5040) in einem Fixierungsvorsprung (5020) als Hohlzylinder, welche die Mantelfläche (5020a) des Fixiervorsprungs um 35 von 100 reduziert und das Mantelvolumen des Hohlzylinders vollständig unterbricht. Als kreissegmentförmig wird hier jene Ausgestaltung definiert, welche sich in der Grundfläche eines Zylinders aus einem Kreisbogen und einer Kreissehne ergibt.
Fig. 6b zeigt eine kreissektorförmige Ausnehmung (5042) in einem Fixierungsvorsprung (5022) als zylindrischen Vollkörper, welche bis zum Mittelpunkt der Grundfläche des zylindrischen Vollkörpers reicht und einen Öffnungswinkel von β = 55° aufweist und welche die Mantelfläche (5022a) des Fixiervorsprungs um 15 von 100 reduziert. Als kreissektorförmig wird hier jene Ausgestaltung definiert, welche sich in der Grundfläche eines Zylinders aus zwei Kreisradien und einem Kreisbogen ergibt.
Fig. 6c zeigt vier jeweils halbkreisförmige Ausnehmungen (5044) in einem Fixierungsvorsprung (5024) als Vollkörper, die in ihrer Summe die Mantelfläche (5042a) des Fixiervorsprungs um insgesamt 40 von 100 reduzieren.

## Patentansprüche

1. Anordnung in Druckkontaktierung mit einem Leistungshalbleitermodul, bestehend aus einem Gehäuse (9), mindestens einem elektrisch isolierenden Substrat (2), mit einer Mehrzahl darauf befindlicher gegeneinander isolierter metallischer Verbindungsbahnen (22), darauf befindlichen und mit diesen Verbindungsbahnen (22) schaltungsgerecht verbundenen Leistungshalbleiterbauelementen (25) sowie zumindest teilweise federnd ausgestalteten Anschlussleitern (30) zur elektrischen Verbindung der Verbindungsbahnen (22) mit einer außerhalb des Gehäuses (9) angeordneten Leiterplatte (4) und mindestens einem formstabilen Druckstück (5) zur Druckkontaktierung der Leiterplatte (4) mit den Anschlussleitern (30), wobei das Druckstück (5) als eine Anordnung mit einem elektrisch isolierenden Kunststoffformteil (50) und einer Metalleinlage (52) aufweist und die Anordnung von Kunststoffformteil (50) und Metalleinlage (52) eine erste (5a) und eine zweite (5b) Hauptfläche des Druckstücks ausbildet,
und wobei das Kunststoffformteil auf einer ersten, zwischen den Hauptflächen (5a, 5b) angeordneten Hilfsfläche (50a) mindestens einen einstückig ausgestalteten Fixierungsvorsprung (502) und die Metalleinlage mindestens eine entsprechend zugeordnete erste Aussparung (522) aufweisen,
und wobei der mindestens eine Fixierungsvorsprung (502) mindestens eine Ausnehmung (504) entlang seiner Hochachse aufweist.

2. Anordnung nach Anspruch 1,
wobei der Fixierungsvorsprung als Vollkörper (5022, 5024) oder als Hohlkörper (502, 5020) ausgestaltet ist.

3. Anordnung nach Anspruch 1,
wobei die mindestens eine Ausnehmung als ein Teilsektor (5042) oder ein Teilsegment (5040) oder mit einer frei definierten Teilfläche (5044) der Grundfläche des Fixierungsvorsprunges ausgestaltet ist.

4. Anordnung nach Anspruch 3,
wobei die mindestens eine Ausnehmung in ihrer Grundfläche einen Öffnungswinkel (α, β, γ) von mindestens 5 Grad aufweist.

5. Anordnung nach Anspruch 3,
wobei die mindestens eine Ausnehmung (504) die Mantelfläche (502a) des Fixiervorsprungs um nicht mehr als 40 von 100 reduziert.

6. Anordnung nach Anspruch 1,
wobei die mindestens eine Ausnehmung (504) fluchtend zu einer der Flächendiagonalen (A-A, B-B) der ersten Hilfsfläche des Kunststoffformteiles ausgerichtet ist.

7. Anordnung nach Anspruch 1,
wobei der mindestens eine Fixierungsvorsprung mit seiner Mantelfläche (502a) einen spezifischen Kraftschluss mit der Innenfläche (522a) der ihm zugeordneten ersten Aussparung (522) aufweist.

8. Anordnung nach Anspruch 1,
wobei das Druckstück (5) mindestens eine seine beiden Hauptflächen (5a, 5b) verbindende zweite Aussparung (58) aufweist.
